# EUROPEAN PATENT APPLICATION

(11) **EP 1 788 120 A1**
(43) Date of publication of application: **23.05.2007**
(21) Application number: 06255881.2
(22) Date of filing: 17.11.2006
(51) Int. Cl.: C23C 16/44, B08B 7/00, H01L 21/00

(54) **Removal of titanium nitride with xenon difluoride**

(30) Priority: 22.11.2005 US 285056
(71) Applicant: Air Products and Chemicals, Inc., Allentown, PA 18195-1501 (US)
(72) Inventor: Wu, Dingjun, Macungie, PA 18062 (US); Karwacki, Eugene Joseph, Jr., Orefield, PA 18069 (US)
(74) Representative: Hatt, Anna Louise

(57) **Abstract**

TiN is at least partially removed, especially selectively etched, from silicon dioxide (quartz) and SiN surfaces by contact with XeF₂ to selectively convert the TiN to a volatile species. XeF₂ can be preformed or formed *in situ* by reaction between Xe and a fluorine compound.

## Description

In the electronics industry various deposition techniques have been developed wherein selected materials are deposited on a target substrate to produce electronic components such as semiconductors. One type of deposition process is chemical vapor deposition (CVD), wherein gaseous reactants are introduced into a heated processing chamber resulting in films being deposited on the desired substrate. One subtype of CVD is referred to as plasma enhanced CVD (PECVD) wherein a plasma is established in the CVD processing chamber.

Generally, all methods of deposition result in the accumulation of films and particulate materials on surfaces other than the target substrate, that is, the deposition materials also collect on the walls, tool surfaces, susceptors, and on other equipment used in the deposition process. Any material, film and the like that builds up on the walls, tool surfaces, susceptors and other equipment is considered a contaminant and may lead to defects in the electronic product component.

It is well accepted that deposition chambers, tools, and equipment must be periodically cleaned to remove unwanted contaminating deposition materials. A generally preferred method of cleaning deposition chambers, tools and equipment involves the use of perfluorinated compounds (PFCs), e.g., C₂F₆, CF₄, C₃F₈, SF₆, and NF₃ as etchant cleaning agents. In these cleaning operations a chemically active fluorine species, which is normally carried in a process gas, converts the unwanted and contaminating residue to volatile products. Then, the volatile products are swept with the process gas from the reactor.

The following references are illustrative of processes for the deposition of films in semiconductor manufacture and the cleaning of deposition chambers, tools and equipment and the etching of substrates:
US 5,421,957 discloses a process for the low temperature cleaning of cold-wall CVD chambers. The process is carried out, *in situ,* under moisture free conditions. Cleaning of films of various materials such as epitaxial silicon, polysilicon, silicon nitride, silicon oxide, and refractory metals, titanium, tungsten and their silicides is effected using an etchant gas, e.g., nitrogen trifluoride, chlorine trifluoride, sulfur hexafluoride, or carbon tetrafluoride.
US 6,051,502 discloses the anisotropic etching of a conduct material using fluorine compounds, e.g., NF₃ and C₂F₆ as etchants in an ion-enhanced plasma. The etchants consist of a fluorine compound and a noble gas selected from the group consisting of He, Ar, Xe and Kr. The substrates tested include integrated circuitry associated with a substrate. In one embodiment a titanium layer is formed over an insulative layer and in contact with the tungsten plug. Then, an aluminum-copper alloy layer is formed above the titanium layer and a titanium nitride layer formed above that.
US 2003/0047691 discloses the use of electron beam processing to etch or deposit materials or repair defects in lithography masks. In one embodiment xenon difluoride is activated by electron beam to etch tungsten and tantalum nitride.
GB 2,183,204 A discloses the use of NF₃ for the *in situ* cleaning of CVD deposition hardware, boats, tubes, and quartz ware as well as semiconductor wafers. NF₃ is introduced to a heated reactor in excess of 350 °C for a time sufficient to remove silicon nitride, polycrystalline silicon, titanium silicide, tungsten silicide, refractory metals and silicides.
Holt, J. R., et al, Comparison of the Interactions of XeF2 and F2 with Si(100)(2X1), J. Phys. Chem. B 2002, 106, 8399-8406 discloses the interaction of XeF₂ with Si(100)(2X1) at 250 K and provides a comparison with F₂. XeF₂ was found to react rapidly and isotropically with Si at room temperature.
Chang, F. I., Gas-Phase Silicon Micromachining With Xenon Difluoride, SPIE Vol. 2641/117-127 discloses the use of XeF₂ as a gas phase, room temperature, isotropic, silicon etchant and noted that it has a high selectivity for many materials used in microelectromechanical systems such as aluminum, photoresist and silicon dioxide. At page 119 it is also noted that XeF₂ has a selectivity of greater than 1000:1 to silicon dioxide as well as copper, gold, titanium-nickel alloy and acrylic when patterned on a silicon substrate.
Isaac, W.C. et al, Gas Phase Pulse Etching of Silicon For MEMS With Xenon Difluoride, 1999 IEEE, 1637-1642 discloses the use of XeF₂ as an isotropic gas-phase etchant for silicon. It is reported that XeF₂ has high selectivity to many metals, dielectrics and polymers in integrated circuit fabrication. The authors also note at page 1637 that XeF₂ did not etch aluminum, chromium, titanium nitride, tungsten, silicon dioxide or silicon carbide. Significant etching also had been observed for molybdenum:silicon and titanium:silicon, respectively.
Winters, et al, The Etching of Silicon With XeF2 Vapor, Appl. Phys. Lett. 34(1) 1 January 1979, 70-73 discloses the use of F atoms and CF₃ radicals generated in fluorocarbon plasma induced dissociation of CF₄ in etching solid silicon to produce volatile SiF₄ species. The paper is directed to the use of XeF₂ to etch silicon at 300 K at 1.4 X 10⁻² Torr (1.8 Pa). Other experiments showed that XeF₂ also rapidly etches molybdenum, titanium and probably tungsten. Etching of SiO₂, Si₃N₄ and SiC was not effective with XeF₂ but etching was effective in the presence of electron or ion bombardment. The authors concluded that etching of these material required not only F atoms but also radiation or high temperature.

There is an industry objective to find new etchants that can be used to remove difficult to remove titanium nitride (TiN) films from silicon dioxide (SiO₂) and silicon nitride (SiN) coated surfaces. These surfaces are found in the walls of semiconductor deposition chambers, particularly quartz chambers and quartz ware, semiconductor tools and equipment. Many of the conventional fluorine based etchants that attack TiN films also attack SiO₂ and SiN surfaces and, therefore, are unacceptable for removing TiN deposition products from semiconductor deposition chambers and equipment.

This invention provides an improved process for the selective removal of titanium nitride (TiN) films and deposition products from silicon dioxide (quartz) surfaces such as those commonly found in semiconductor deposition chambers and semiconductor tools as well as silicon nitride (SiN) surfaces commonly found in semiconductor tool parts and the like. In a basic process for removing undesired components contaminating a surface an etchant is contacted with the undesired component in a contact zone and the undesired component converted to a volatile species. The volatile species then is removed from the contact zone. An improvement in the basic process for removing undesired TiN deposition materials from a surface selected from the group consisting of SiO₂ and SiN in a contact zone resides in employing xenon difluoride (XeF₂) as the etchant. Conditions may be controlled so that said surface selected from the group consisting of SiO₂ and SiN is not converted to a volatile component.

Significant advantages in terms of selective etching of TiN films and deposition materials which are very difficult to remove from semiconductor deposition chambers (sometimes referred to as reaction chambers), tool parts, equipment and the like include:
an ability to selectivity remove TiN films from quartz, i.e., SiO₂, and SiN coated surfaces found in the cleaning of deposition chambers;
an ability to remove TiN films from quartz surfaces at modest temperatures; and,
an ability to activate perfluoro etching agents in remote plasma to remove TiN films from SiO₂ and SiN surfaces without adverse effects normally caused by fluorine atoms attacking in the remote plasma.

In a first aspect, the invention relates to a process for the selective etching of titanium nitride from a surface containing silicon dioxide or silicon nitride, comprising the steps:
contacting the surface containing silicon dioxide or silicon nitride with an etchant gas comprised of xenon difluoride in a contact zone to selectively convert said titanium nitride to a volatile species preferentially to converting said silicon dioxide or silicon nitride to a volatile component; and,
removing said volatile species from said contact zone.

In a first preferred embodiment of this aspect of the invention, the xenon difluoride is preformed prior to introduction to said contacting zone and the temperature of said contacting is at least 100 °C. More preferably, the temperature during said contacting is from 150 to 500 °C.

Preferably, the pressure in said contact zone is at least 0.1 Torr (13 Pa). More preferably, the pressure is from 0.2 to 10 Torr (27 Pa to 1.3 kPa).

Preferably, said surface is coated with silicon dioxide. In an alternative preferred embodiment of this aspect of the invention, the xenon difluoride is formed *in situ* by the reaction of xenon with a fluorine compound.

Preferably, the *in situ* formation of xenon difluoride is effected by contacting xenon with said fluorine compound in a remote plasma generator.

Preferably, the fluorine compound is selected from the group consisting of NF₃, C₂F₆, CF₄, C₃F₈, and SiF₆.

Preferably, the temperature in the contact zone is from 50 to 500 °C. More preferably, the temperature employed in said contacting zone is from 100 to 300 °C.

Preferably, the etchant gas is comprised of the *in situ* formed xenon difluoride and argon.

Preferably, the mole ratio of Xe to fluorine compound is from 1:10 to 10:1.

Preferably, the pressure is from 1 to 10 Torr (130 Pa to 1.3 kPa).

In a second aspect, the invention relates to, in a process for cleaning a semiconductor deposition chamber from unwanted deposition residue wherein the unwanted deposition residue is contacted with an etchant gas to convert said unwanted residue to a volatile species and then removing the volatile species from said deposition chamber, the improvement which comprises:
removing an unwanted deposition residue comprised of titanium nitride from a semiconductor deposition chamber incorporating a surface of silicon dioxide or silicon nitride using xenon difluoride as said etchant gas.

In a first preferred embodiment of this aspect of the invention, the xenon difluoride is preformed prior to contact with said unwanted residue.

Preferably, the temperature during said contacting is from 150 to 500 °C and the pressure is from 0.2 to 10 Torr (27 Pa to 1.3 kPa).

In an alternative preferred embodiment of this aspect of the invention, the xenon difluoride is formed *in situ* by the reaction of xenon with a fluorine compound and the *in situ* formation of xenon difluoride is effected by contacting xenon with said fluorine compound in a remote plasma generator.

Preferably, the fluorine compound is selected from the group consisting of NF₃, C₂F₆, CF₄, C₃F₈, and SiF₆.

In a third aspect, the invention provides a process for the selective etching of titanium nitride from a surface containing silicon dioxide or silicon nitride, comprising the steps:
contacting the surface containing silicon dioxide or silicon nitride with an etchant gas in a contact zone to selectively convert said titanium nitride to a volatile species preferentially to converting said silicon dioxide or silicon nitride to a volatile component; and,
removing said volatile species from said contact zone,
wherein the etchant gas is formed *in situ* by the reaction of xenon with a fluorine compound.

Features described in connection with one aspect of the invention can also be used in connection with other aspects of the invention.

The invention will be further described with reference to the Examples and to the Figures, in which:
Fig. 1 is a plot of the etch rate of a silicon substrate as a function of the level of Xe vis-à-vis Ar in an NF₃ remote plasma.
Fig. 2 is a plot of the etch rate of SiO₂ as a function of the level of Xe vis-à-vis Ar in an NF₃ remote plasma.
Fig. 3 is a plot comparing the etch selectivity of silicon to silicon dioxide as a function of the level of Xe vis-à-vis Ar in an NF₃ remote plasma.
Fig. 4 is a plot of the etch rate of TiN as a function of temperature and the level of Xe vis-à-vis Ar in an NF₃ remote plasma.
Fig. 5 is a plot of the etch rate of silicon dioxide as a function of temperature and the level of Xe vis-à-vis Ar in an NF₃ remote plasma.
Fig. 6 is a plot comparing the etch selectivity of TiN to silicon dioxide as a function of the level of Xe vis-à-vis Ar in an NF₃ remote plasma.

The deposition of titanium nitride (TiN) is commonly practiced in the electronics industry in the fabrication of integrated circuits, electrical components and the like. In the deposition process some of the TiN is deposited on surfaces other than the surface of the target substrate, e.g., walls and surfaces within the deposition chamber. It has been found that XeF₂ is effective as a selective etchant for TiN contaminating silicon dioxide (SiO₂) and silicon nitride (SiN) surfaces. With this finding one can use xenon difluoride (XeF₂) as an etchant for removing unwanted TiN films and deposition materials contaminating surfaces such as those found in semiconductor reactor or deposition chambers, tools, equipment, parts, and chips coated or lined with silicon dioxide (quartz) or silicon nitride.

In the removal of unwanted TiN residues from SiO₂ and SiN surfaces, such as those in a deposition chamber, XeF₂ is contacted with the surface in a contact zone under conditions for converting TiN to volatile TiF₄, and then removing the volatile species from the contact zone. Often, the XeF₂ is added along with an inert gas, e.g., N₂, Ar, He, or the like.

In carrying out the process for removing TiN deposition materials from SiN and SiO₂ surfaces, XeF₂ may be preformed prior to introduction to the contact zone, or for purposes of this invention, and by definition herein, XeF₂ may be formed *in situ* by two methods. In one embodiment of the *in situ* formation of XeF₂, at least this is believed to be the resulting product from the perceived reaction, xenon (Xe) is added to a fluorine compound and charged to a remote plasma generator. There Xe reacts with F atoms present in the resulting remote plasma to form XeF₂. In a variation of the *in situ* embodiment, the fluorine compound is added to the remote plasma generator and then Xe is added to remote plasma containing F atoms downstream of the remote plasma generator.

Illustrative of this, fluorine compounds for forming XeF₂ via the *in situ* method include NF₃, perfluorocarbons as C₂F₆, CF₄, C₃F₈, and sulfur derivatives such as SF₆. In the preferred embodiment NF₃ is used as the fluorine compound for the *in situ* formation of XeF₂.

A wide range of Xe to fluorine compound can be used in the *in situ* process of forming XeF₂. The mole ratio of Xe to fluorine compound is dependent upon the amount of XeF₂ formed vis-à-vis the level of F atoms in the remote plasma. Preferred mole ratios are from 1:10 to 10:1 Xe to fluorine compound. Optionally an inert gas, e.g., argon, can be included in the remote plasma generation of XeF₂ as a means of adjusting the selectivity etching of TiN to SiO₂ and SiN.

Temperatures for effecting selective etching of TiN films from silicon dioxide surfaces (quartz) and SiN surfaces depend primarily on by which method the process is carried out. By that it is meant that if XeF₂ is preformed and added directly to the contact zone, temperatures should be elevated to at least 100 °C, e.g., 100 to 800 °C, preferably from 150 to 500°C. Pressures for XeF₂ should be at least 0.1 Torr (13 Pa), e.g., 0.1 to 20 Torr (13 Pa to 2.7 kPa), preferably from 0.2 to 10 Torr (27 Pa to 1.3 kPa). In contrast to prior art processes where the rate of etching (Si etching) decreases as the temperature is increased, here the rate of etching increases with an increase in temperature. It is believed the increase in temperature increases the rate of TiN etching because TiF₄ is volatile under these conditions and is easily removed from the SiO₂ and SiN surface. Lower temperatures leave TiF₄ species near the SiO₂ and SiN surfaces blocking the attack of XeF₂.

In the *in situ* process of forming XeF₂ cleaning or etching is done in the presence of a remote plasma. Temperatures when a remote plasma is present may range from 50 to 500 °C, preferably from 100 to 300 °C.

Pressures suited for the removal of TiN from SiO₂ and SiN surfaces range from 0.5 to 50 Torr (67 Pa to 6.7 kPa), preferably from 1 to 10 Torr (130 Pa to 1.3 kPa).

The following examples are provided to illustrate various embodiments of the invention and are not intended to restrict the scope thereof.

### Example 1

### Effectiveness of XeF₂ In Etching Of Deposition Materials At Various Temperatures and Pressures

In this example, the etch rates for TiN, SiO₂, and SiN were determined using XeF₂ as the etchant at various temperatures and pressures. Experimental samples were prepared from Si wafers coated with thin films of TiN, SiO₂, and SiN. Etch rates were calculated by the thin film thickness change between the initial film thickness and that thickness after a timed exposure to the etching or processing conditions.

To effect etching bulk XeF₂ gas was introduced from a cylinder into the reactor chamber through an unused remote plasma generator. The XeF₂ gas pressure in the reactor chamber was held constant by turning off the flow from the cylinder once the desired pressure was reached.

The test coupons were placed on the surface of a pedestal heater which was used to maintain different substrate temperatures. The results are shown in Table 1 below.

**Table 1**

| ETCH RATES FOR VARIOUS MATERIALS USING XeF₂ | | | |
|---|---|---|---|
| Material | Temperature (°C) | Pressure (Torr (Pa)) | Etch Rate (nm/min) |
| TiN | 25 | 1 (130) | 0 |
| TiN | 100 | 1 (130) | 0 |
| TiN | 150 | 1(130) | 8 |
| TiN | 200 | 1 (130) | 13 |
| TiN | 300 | 0.5 (67) | 20 |
| SiO₂ | 300 | 0.5 (67) | 0 |
| SiN | 100 | 1 (130) | 0 |
| SiN | 150 | 1 (130) | 0 |
| SiN | 300 | 1 (130) | 0 |

The above results show that, at a pressure of 0.5 to 1 Torr (67 to 130 Pa), XeF₂ was effective in etching TiN films at elevated temperatures of from 150 to 300 °C and ineffective at 25 °C room temperature. Surprisingly XeF₂ did not etch an SiO₂ or an SiN surface at any of the temperatures and pressures employed but did etch TiN films at such temperatures. Because of the inability of XeF₂ to etch SiO₂ and SiN surfaces at these elevated temperatures, but its ability to etch TiN films, it was concluded that XeF₂ could be used as a selective etching agent for TiN films and particles from SiO₂ and SiN surfaces.

### Example 2

### In Situ Formation of XeF₂ Via Reaction Of Xe and NF₃

In this example, an MKS Astron remote plasma generator was mounted on top of a reactor chamber. The distance between the exit of the Astron generator and the sample coupon was about six inches (15 cm). The remote plasma generator was turned on but the pedestal heater in the reactor chamber was turned off. The chamber was kept at room temperature. The etch rate of both Si and SiO₂ substrates using remote plasma was measured for comparative purposes.

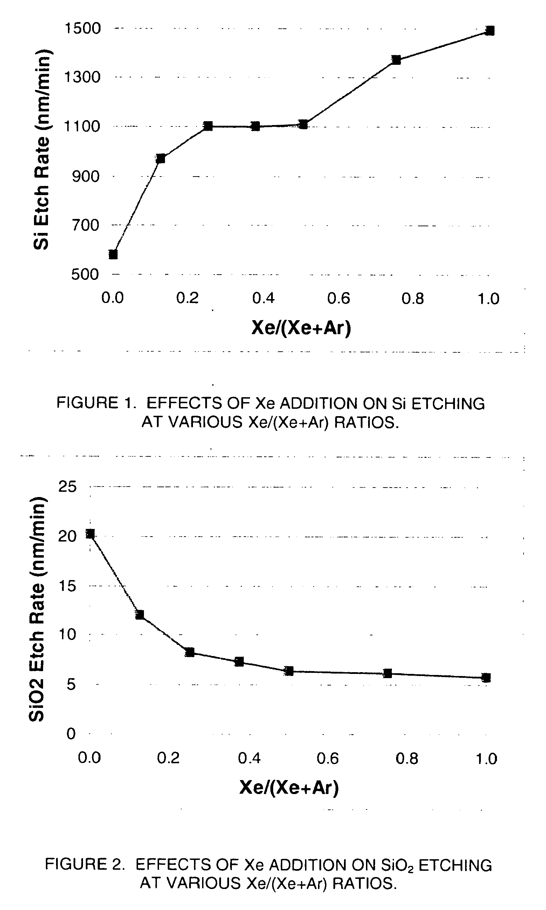

The process gas to the remote plasma was NF₃ and it was mixed with a second gas stream in various amounts. The second gas stream was comprised of either Xe, argon (Ar), or a combination thereof. The total gas flowrate to the reactor chamber was fixed at 400 sccm (standard cubic centimetres per minute) and the NF₃ flowrate was fixed at 80 sccm. While keeping the total flowrate of the second gas stream at 320 sccm, the ratio of the flowrate of Xe to the total flowrate of the second gas stream (Xe/(Ar+Xe)) was varied between 0 (only Ar as the additional process gas) and 1 (only Xe as the additional process gas). The results of Si substrate etching are shown in Fig. 1 and the results of SiO₂ substrate etching are shown in Fig. 2.

As Figure 1 shows, addition of Xe to the process gas, NF₃, enhanced the Si etch rate. What was unexpected is that the addition of Xe to a remote plasma generator along with NF₃ would generate a plasma that enhanced Si etching.

Fig. 2 shows that the addition of Xe to an NF₃/argon plasma inhibited the SiO₂ substrate etch rate and this was unexpected. F atoms present in a remote plasma attack SiO₂ based substrates. Along with the analysis of Fig. 1, it was surmised that the addition of Xe to the plasma resulted in the *in situ* formation of XeF₂ resulting in enhancing Si substrate etching, but reducing or inhibiting SiO₂ substrate etching as noted in Example 1.

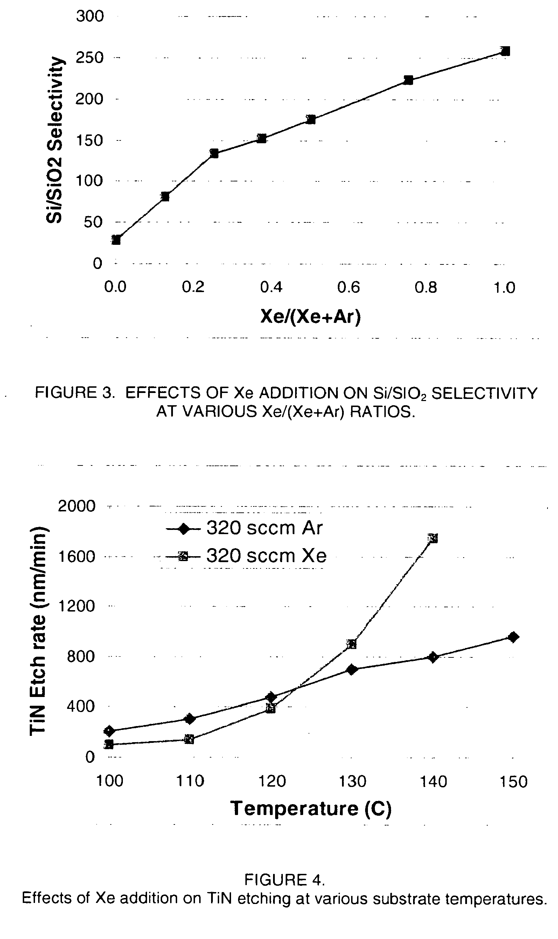

Fig. 3 is provided to compare the effect of the addition of Xe to the NF₃ process gas on the etch selectivity for Si vis-à-vis SiO₂. As can be seen by comparing the results in Figures 1 and 2, Fig. 3 shows that the etch selectivity for Si relative to SiO₂ increased as the amount of Xe in the process gas was increased. Specifically, the selectivity increased from 30 to 250 as the percentage of Xe in the gas stream was increased from 0% to 100%.

### Example 3

### Effect of Remote Plasma and Temperature On Etch Rate Of TiN and SiO₂

In this example the procedure of Example 2 was followed except both the remote plasma generator and the pedestal heater were turned on to allow for determination of the etch rate of both TiN and SiO₂ using remote plasma at various substrate temperatures.

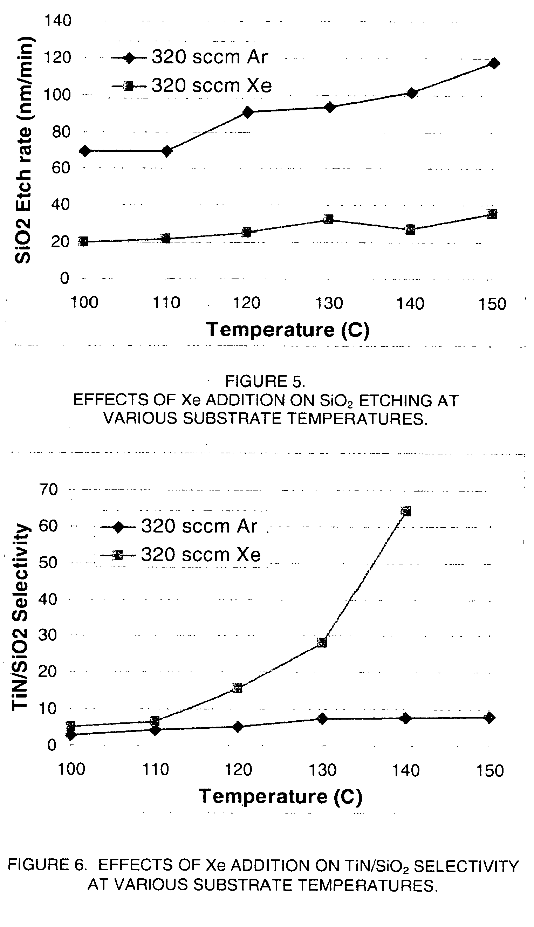

In a first set of experiments the etch rate of TiN and SiO₂ was measured using a mixture of NF₃ and Xe as the process gas. The flowrate of Xe was fixed at 320 sccm. The temperature was varied from 100 °C to 150 °C. The results of these experiments are shown as the square points in Figures 4 and 5 for TiN and SiO₂, respectively.

In a second set of experiments the etch rate of TiN and SiO₂ was measured using a mixture of NF₃ and argon (Ar) as the process gas. The flowrate of Ar was fixed at 320 sccm. The temperature was varied from 100 °C to 150 °C. The results of these experiments are shown as the diamond points in Figures 4 and 5 for TiN and SiO₂, respectively.

As Figure 4 shows, the addition of Xe to the process gas enhanced the TiN etch rate at temperatures generally above 130 °C. Figure 5 shows that the addition of Xe to NF₃ inhibited the SiO₂ etch rate for all temperatures studied vis-à-vis the addition of Ar to NF₃. The effect of the addition of Xe to the process gas on the etch selectivity can be seen by comparing the results in Figures 4 and 5.

Figure 6 shows the etch selectivity for TiN relative to SiO₂ and the graph shows that the TiN selectivity begins to increase at temperatures above about 110 °C, and rapidly above 120 °C, with the addition of Xe to the NF₃ process gas relative to Ar.

Summarizing, Example 1 shows that XeF₂ is a selective etchant for TiN films in relation to silicon dioxide and silicon nitride substrates when such etching is performed at elevated temperatures. Example 3 shows that the addition of Xe to an NF₃ process gas in a remote plasma can increase the etch selectivity of TiN relative to SiO₂ at high (elevated) temperatures as compared to the etch selectivity when only NF₃ is used as the process gas. The increased selectivity of TiN relative to SiO₂ is important in quartz tube furnace applications and to parts and semiconductor tools coated with SiO₂ having TiN deposits thereon. This methodology may facilitate the cleaning of deposition reactors in between deposition cycles by interfacing a remote downstream plasma unit onto the process reactor and admitting the process gases. There may be economic advantages (i.e., lower cost of ownership) of combining xenon with a fluorine containing gas such as NF₃ rather than employing XeF₂ for such a cleaning process. The cleaning process described in this example could also be employed in an off-line process reactor whose sole purpose is to clean process reactor parts prior to their re-use. Here, a remote downstream plasma reactor would be interfaced onto an off-line process reactor into which parts (components from the deposition reactor) are placed. Xenon and a fluorine containing gas such as NF₃ would then be introduced to the remote downstream unit prior to the admission of the process gases into the chamber containing the parts to be cleaned.

## Claims

1. A process for the selective etching of titanium nitride from a surface containing silicon dioxide and/or silicon nitride, comprising the steps:
contacting the surface containing silicon dioxide and/or silicon nitride with an etchant gas comprising xenon difluoride in a contact zone to selectively convert said titanium nitride to a volatile species preferentially to converting said silicon dioxide and/or silicon nitride to a volatile component; and,
removing said volatile species from said contact zone.

2. A process for cleaning a semiconductor deposition chamber incorporating a surface comprising silicon dioxide and/or silicon nitride from unwanted deposition residue comprising titanium nitride, wherein the unwanted deposition residue is contacted with xenon difluoride as an etchant gas to convert said unwanted residue to a volatile species and the volatile species is then removed from said deposition chamber.

3. The process of Claim 1 or Claim 2 wherein the xenon difluoride is preformed prior to introduction to said contacting zone and/or prior to contact with said unwanted residue.

4. The process of Claim 3, wherein the temperature of said contacting is at least 100 °C.

5. The process of Claim 4, wherein the temperature during said contacting is from 150 to 500 °C.

6. The process of any one of Claims 2 to 5, wherein the pressure in said contact zone is at least 13 Pa (0.1 Torr).

7. The process of Claim 6, wherein the pressure is from 27 Pa to 1.3 kPa (0.2 to 10 Torr).

8. The process of Claim 1 or Claim 2, wherein the xenon difluoride is formed *in situ* by the reaction of xenon with a fluorine compound.

9. The process of Claim 8 wherein the *in situ* formation of xenon difluoride is effected by contacting xenon with said fluorine compound in a remote plasma generator.

10. The process of Claim 8, wherein the *in situ* formation of xenon difluoride is effected by adding said fluorine compound to the remote plasma generator and then adding xenon to remote plasma containing fluorine atoms downstream of the remote plasma generator.

11. The process of any one of Claims 8 to 10, wherein the fluorine compound is selected from the group consisting of NF₃, C₂F₆, CF₄, C₃F₈, SF₆ and a mixture of two or more thereof.

12. The process of any one of Claims 8 to 11, wherein the temperature in the contact zone is from 50 to 500 °C.

13. The process of Claim 12, wherein the temperature employed in said contacting zone is from 100 to 300 °C.

14. The process of any one of Claims 8 to 13, wherein the mole ratio of Xe to fluorine compound is from 1:10 to 10:1.

15. The process of any one of Claims 8 to 14, wherein the pressure is from 130 Pa to 1.3 kPa (1 to 10 Torr).

16. The process of any one of the preceding claims, wherein said surface is coated with silicon dioxide.

17. The process of any one of the preceding claims wherein the etchant gas comprises xenon difluoride and argon.
